# EUROPÄISCHE PATENTSCHRIFT

(11) **EP 1 921 748 B1**
(45) Veröffentlichungstag und Bekanntmachung des Hinweises auf die Patenterteilung: **25.08.2010**
(21) Anmeldenummer: 07017789.4
(22) Anmeldetag: 11.09.2007
(51) Int. Cl.: H03L 7/087

(54) **Phasendetektoranordnung**
Phase detector assembly
Agencement de détecteur de phases

(30) Priorität: 09.11.2006 DE 102006052867
(43) Veröffentlichungstag der Anmeldung: 14.05.2008
(73) Patentinhaber: Rohde & Schwarz GmbH & Co. KG, 81671 München (DE)
(72) Erfinder: Kuptz, Johannes, 85560 Ebersberg (DE)
(74) Vertreter: Körfer, Thomas

(56) Entgegenhaltungen:
- EP-A- 1 199 805
- JP-A- 2001 156 627
- US-A- 4 940 952
- US-A1- 2006 050 821
- WANG H ET AL: "A 1GB/S CMOS CLOCK AND DATA RECOVERY CIRCUIT" IEEE INTERNATIONAL SOLID STATE CIRCUITS CONFERENCE, IEEE SERVICE CENTER, NEW YORK, NY, US, Bd. 42, Februar 1999 (1999-02), Seiten 354-355,477, XP000862367 ISSN: 0193-6530
- WANG H ET AL: "A CMOS low-jitter phase frequency detector for giga-bit/s clock recovery" DESIGN OF MIXED-MODE INTEGRATED CIRCUITS AND APPLICATIONS, 1999. THIRD INTERNATIONAL WORKSHOP ON PUERTO VALLARTA, MEXICO 26-28 JULY 1999, PISCATAWAY, NJ, USA,IEEE, US, 26. Juli 1999 (1999-07-26), Seiten 91-93, XP010376236 ISBN: 0-7803-5588-1

## Beschreibung

Die Erfindung betrifft eine Phasendetektoranordnung für die Phasenregelschleife eines phasengeregelten Hochfrequenz-Oszillators (VCO).

Eine Phasendetektoranordnung der eingangs erwähnten Art ist in Fig. 1 dargestellt. Ein ähnlicher Phasendetektor ist z. B. in der EP 0 283 275 beschrieben.

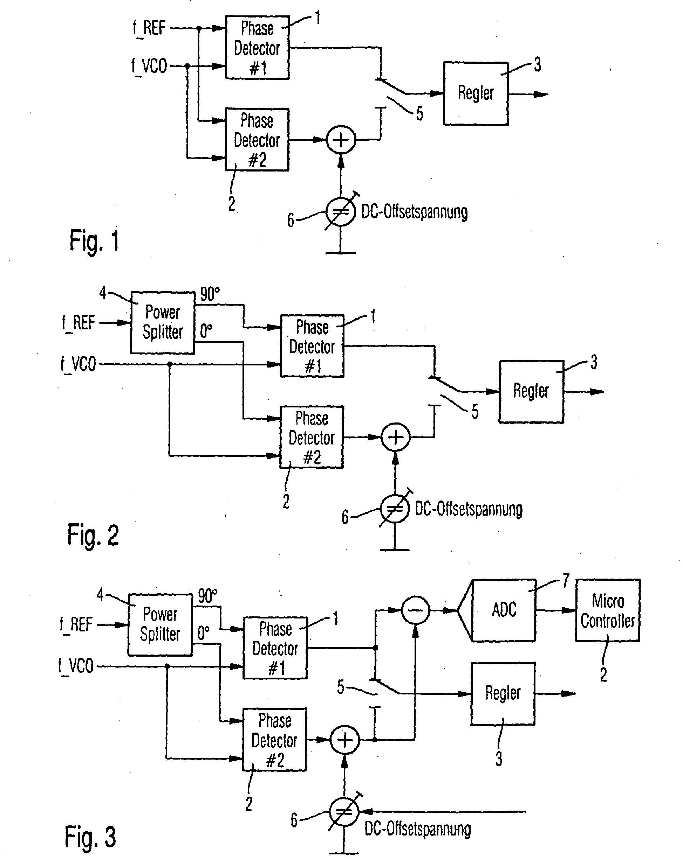

Um eine möglichst rauscharme Phasenregelschleife zu erhalten ist es bekannt, einen besonders rauscharmen Phasendetektor einzusetzen, beispielsweise einen Mischer-Phasendetektor oder einen XOR-Phasendetektor, wie er beispielsweise beschrieben ist bei Roland Best "Theorie und Anwendungen des Phase-Locked Loops", vde Verlag Seiten 96 bis 103, ISBN 3-8007-1980-0, 5. Auflage. Solche rauscharmen Phasendetektoren können aber nur einen Phasenunterschied detektieren, nicht jedoch einen Frequenzunterschied. Sie haben auch nur einen Aussteuerungsbereich von 180°. Deshalb kann man gemäß Fig. 1 einen solchen rauscharmen Phasendetektor 1 mit einem flankengetriggerten digitalen Phasendetektor 2 kombinieren, der frequenzselektiv ist und einen größeren Aussteuerungsbereich besitzt, dafür aber nicht so rauscharm ist. Um eine Phasenregelschleife eines VCO schnell und sicher zum Einrasten zu bringen, wird bei einer solchen kombinierten Phasendetektoranordnung nach Fig. 1 zunächst der digitale Phasendetektor 2 aktiviert und dann, wenn die Regelschleife eingerastet ist, mittels eines Schalters 5 auf den rauscharmen Phasendetektor 1 (Mischer- oder XOR-Phasendetektor) umgeschaltet.

Ein Problem dabei ist, dass die erwähnten rauscharmen Phasendetektoren wie Mischer- und XOR-Phasendetektoren den Nullpunkt der Kennlinie bei 90° aufweisen, beim digitalen Phasendetektor jedoch bei 0°. Nach dem Umschalten ist daher ein erneuter Einschwingvorgang notwendig, um von 0° Phasendifferenz auf 90° Phasendifferenz zu gelangen. Um diesen erneuten Einschwingvorgang zu vermeiden kann zwar dem Ausgangssignal des einen Phasendetektors eine passende DC-Offsetspannung zugesetzt werden, dies führt aber zu einem unsymmetrischen Aussteuerungsbereich.

Die JP 2001 156 627 zeigt einen Phasendetektor gemäß dem Oberbegriff von Anspruch 1.

Es ist daher Aufgabe der Erfindung, eine Phasendetektoranordnung dieser Art so weiterzubilden und zu verbessern, dass ein erneutes Einschwingen bzw. ein unsymmetrischer Aussteuerungsbereich vermieden wird.

Diese Aufgabe wird durch die Merkmale des Anspruchs 1 gelöst. Vorteilhafte Weiterbildungen ergeben sich aus den Unteransprüchen.

Gemäß der Erfindung wird entweder das Referenzsignal oder das VCO-Ausgangssignal jeweils um 90° phasenverschoben dem einen Phasendetektor zugeführt während dem anderen Phasendetektor die Signale wie bisher gleichphasig zugeführt werden. Auf diese Weise wird ein erneuter Einschwingvorgang nach dem Umschalten vom digitalen Phasendetektor auf rauscharmen Phasendetektor vermieden und auch eine Unsymmetrie des Aussteuerungsbereiches, da keine DC-Offsetspannung nötig ist. Als rauscharme Phasendetektoren sind hierbei insbesondere Mischer- und XOR-Phasendetektoren geeignet, wie sie in der oben genannten Literaturstelle beschrieben sind.

Die Erfindung wird im Folgenden anhand schematischer Zeichnungen an zwei Ausführungsbeispielen näher erläutert.

Es zeigen:
- Fig. 1: ein Blockschaltbild des Ausgangspunkts der Erfindung;
- Fig. 2: eine erfindungsgemäße Phasendetektoranordnung mit manueller Kennlinienfehlerkorrektur; und
- Fig. 3: eine erfindungsgemäße Phasendetektoranordnung mit automatischer Kennlinienkorrektur.

Die Phasendetektoranordnung nach Fig. 2 besteht aus einem rauscharmen Phasendetektor 1, beispielsweise einem Mischer- oder XOR-Phasendetektor, sowie einem flankengetriggerten digitalen Phasendetektor 2. Insoweit stimmt diese Anordnung überein mit der Phasendetektoranordnung nach Fig. 1.

Das Referenzsignal f_{REF} wird aus einer nicht dargestellten Referenzfrequenzquelle zugeführt, das Ausgangssignal f_{VCO} vom Ausgang des nicht dargestellten phasengeregelten Hochfrequenzoszillators VCO, der in der Frequenz und Phase über die Regelschleife 3 entsprechend geregelt ist. Im Gegensatz zum Stand der Technik nach Fig. 1 wird die Referenzfrequenz f_{REF} über einen zwischengeschalteten 90°-Leistungsteiler 4 den beiden Phasendetektoren 1 und 2 zugeführt und zwar im Beispiel mit 90° Phasenverschiebung dem Phasendetektor 1 und mit 0° Phasenverschiebung dem Phasendetektor 2.

Das Ausgangssignal des VCO wird gleichphasig den beiden Phasendetektoren 1 und 2 zugeführt. Es könnte auch umgekehrt das Ausgangssignal des HF-Oszillators VCO entsprechend 90° phasenverschoben den beiden Phasendetektoren zugeführt werden und das Referenzsignal entsprechend phasengleich. Welche Variante sinnvoller ist, ergibt sich aus der Phasenlage der Phasenregelschleife.

Im dargestellten Beispiel ist also das Referenzsignal für den digitalen Phasendetektor 2 gegenüber dem Referenzsignal für den Mischer- oder XOR-Phasendetektor 1 um 90° in der Phase verschoben. Dadurch gibt es keinen erneuten Einschwingvorgang beim Umschalten der Regelschleife 3 über den Schalter 5 vom digitalen Phasendetektor 2 zum rauscharmen Phasendetektor 1 und auch keine unsymmetrische Kennlinie. Kleine Abweichungen vom idealen Kennlinien-Nullpunkt können zwar zu einem geringen Restfehler führen, der aber leicht durch eine einstellbare DC-Offsetspannung 6 minimiert werden kann, die dem Ausgangssignal eines der beiden Phasendetektoren, im Ausführungsbeispiel dem Phasendetektor 2, über eine zusätzliche Addierschaltung hinzugefügt wird.

Fig. 3 zeigt die gleiche Anordnung jedoch ergänzt durch eine Regelschaltung zum automatischen Optimieren der Einstellung der DC-Offsetspannung. Da die Ausgangssignale der beiden Phasendetektoren 1 und 2 gleichzeitig verfügbar sind, kann auf einfache Weise die Differenz der Ausgangsspannungen dieser Phasendetektoren 1 und 2 samt DC-Offsetspannung gemessen und über einen Analaog/Digital-Wandler und einen geeigneten Mikrocontroller 8 eine programmierbare Regelspannung zum Einstellen der DC-Offsetspannung 6 vorgesehen werden.

## Patentansprüche

1. Phasendetektoranordnung für die Phasenregelschleife in einem phasengeregelten Hochfrequenzoszillator (VCO), umfassend einen rauscharmen Phasendetektor (1) mit Kennliniennullpunkt bei 90° und einen digitalen Phasendetektor (2) mit Kennliniennullpunkt bei 0°, wobei die Phasenregelschleife zwischen dem rauscharmen Phasendetektor (1) und dem digitalen Phasendetektor (2) umschaltbar ist und das Ausgangssignal des Hochfrequenzoszillators (f_VCO) mit einem Referenzsignal (f_REF) verglichen wird,
**dadurch gekennzeichnet,**
**dass** entweder das Referenzsignal (f_REF) über einen 90°-Leistungsteiler nur dem rauscharmen Phasendetektor (1) mit 90° Phase und nur dem digitalen Phasendetektor (2) mit 0° Phase zugeführt wird, während das Ausgangssignal des Hochfrequenzoszillators (f_VCO) gleichphasig den beiden Phasendetektoren (1, 2) zugeführt wird oder
das Ausgangssignal des Hochfrequenzoszillators (f_VCO) über einen 90°-Leistungsteiler nur dem rauscharmen Phasendetektor (1) mit 90° Phase und nur dem digitalen Phasendetektor (2) mit 0° Phase zugeführt wird während das Referenzsignal (f_REF) gleichphasig den beiden Phasendetektoren (1, 2) zugeführt wird,
**dass** zur Kennlinien-Nullpunktkorrektur dem Ausgang eines der beiden Phasendetektoren (1, 2) eine einstellbare Offset-Gleichspannung (6) zuführbar ist und die einstellbare Offset-Gleichspannung (6) über einen Regelkreis (7, 8) in Abhängigkeit vom Vergleich der Ausgangsspannungen der beiden Phasendetektoren (1, 2) geregelt ist.

## Claims

1. Phase detector arrangement for the phase-locked loop in a phase-controlled radio-frequency oscillator (VCO), comprising a low-noise phase detector (1) with a characteristic curve zero point at 90° and a digital phase detector (2) with a characteristic curve zero point at 0°, the phase-locked loop being able to be changed over between the low-noise phase detector (1) and the digital phase detector (2), and the output signal from the radio-frequency oscillator (f_VCO) being compared with a reference signal (f_REF), **characterized in that**
either the reference signal (f_REF) is supplied, via a 90° power splitter, only to the low-noise phase detector (1) with a phase of 90° and only to the digital phase detector (2) with a phase of 0°, whereas the output signal from the radio-frequency oscillator (f_VCO) is supplied to the two phase detectors (1, 2) with the same phase, or
the output signal from the radio-frequency oscillator (f_VCO) is supplied, via a 90° power splitter, only to the low-noise phase detector (1) with a phase of 90° and only to the digital phase detector (2) with a phase of 0°, whereas the reference signal (f_REF) is supplied to the two phase detectors (1, 2) with the same phase, and
**in that**, in order to correct the characteristic curve zero point, an adjustable DC offset voltage (6) can be supplied to the output of one of the two phase detectors (1, 2) and the adjustable DC offset voltage (6) is controlled, on the basis of the comparison of the output voltages of the two phase detectors (1, 2), via a control loop (7, 8).

## Revendications

1. Dispositif de détecteur de phase pour la boucle à verrouillage de phase dans un oscillateur haute fréquence à boucle de verrouillage de phase (VCO) comprenant un détecteur de phase silencieux (1) avec un point zéro de courbe caractéristique à 90° et un détecteur de phase numérique (2) avec un point zéro de courbe caractéristique de 0°, dans lequel la boucle à verrouillage de phase peut être commutée entre le détecteur de phase silencieux (1) et le détecteur de phase numérique (2) et le signal de sortie de l'oscillateur haute fréquence (f_VCO) est comparé à un signal de référence (f_REF),
**caractérisé en ce que**
soit le signal de référence (f_REF) est délivré par l'intermédiaire d'un diviseur de puissance de 90° uniquement au détecteur de phase silencieux (1) avec une phase de 90° et uniquement au détecteur de phase numérique (2) avec une phase de 0°, tandis que le signal de sortie de l'oscillateur haute fréquence (f_VCO) est délivré en phase aux deux détecteurs de phase (1, 2), ou
soit le signal de sortie de l'oscillateur haute fréquence (f_VCO) est délivré par l'intermédiaire d'un diviseur de puissance de 90° uniquement au détecteur de phase silencieux (1) avec une phase de 90° et uniquement au détecteur de phase numérique (2) avec une phase de 0° tandis que le signal de référence (f_REF) est délivré avec la même phase aux deux détecteur de phase (1, 2),
**en ce que**, en vue de la correction du point zéro de courbe caractéristique, une tension continue de décalage réglable (6) peut être délivrée à la sortie d'un des deux détecteurs de phase (1, 2) et la tension égale de décalage réglable (6) est réglée par l'intermédiaire d'un circuit de réglage (7, 8) selon la comparaison des tensions de sortie des deux détecteurs de phase (1, 2).
